# FASCICULE DE BREVET EUROPEEN

(11) **EP 0 522 114 B1**
(45) Date de publication et mention de la délivrance du brevet: **06.08.1997**
(21) Numéro de dépôt: 92902834.8
(22) Date de dépôt: 20.12.1991
(51) Int. Cl.: H03F 1/20

(54) **DISPOSITIF DE TRANSMISSION DE SIGNAUX A PROPAGATION D'ONDES ET APPLICATIONS DUDIT DISPOSITIF POUR L'AMPLIFICATION DE TELS SIGNAUX**
SENDEEINRICHTUNG FÜR WELLENAUSBREITUNGSSIGNALE UND DEREN ANWENDUNGEN ZUR VERSTÄRKUNG SOLCHER SIGNALE
WAVE PROPAGATION SIGNAL TRANSMISSION DEVICE AND APPLICATIONS THEREOF FOR AMPLIFIYING SUCH SIGNALS

(30) Priorité: 21.12.1990 FR 9016175
(43) Date de publication de la demande: 13.01.1993
(73) Titulaire: PRANA RECHERCHE ET DEVELOPPEMENT, 91680 Bruyères-le-Châtel (FR)
(72) Inventeur: CHAHBAZIAN, Jacques, F-91680 Bruyères-le-Châtel (FR)
(74) Mandataire: Poidatz, Emmanuel
(86) Numéro de dépôt international: FR9101056
(87) Numéro de publication internationale: WO9211693

(56) Documents cités:
- GB-A- 963 185
- US-A- 2 785 338
- US-A- 2 870 374
- US-A- 3 247 420
- US-A- 3 808 546
- US-A- 4 091 332

## Description

La présente invention concerne des dispositifs de transmission de signaux à propagation d'ondes d'un type nouveau, utilisables notamment pour la réalisation d'amplificateurs H.F. de puissance à large bande. L'amplificateur H.F. à large bande passante (de BF à VHF) est couramment obtenu à l'aide de tubes de puissance fonctionnant en constantes localisées. Ces tubes présentent des dimensions et des caractéristiques physiques et électriques définies ponctuellement (courant, capacités/inductances d'entrée et de sortie, pouvoir amplificateur entre un niveau d'entrée et un niveau de sortie, etc...).

Il a été proposé d'accroître les dimensions des tubes à vide et la surface des électrodes dans le but d'augmenter l'amplification de puissance. L'accroissement correspondant des capacités d'entrée et de sortie a pour effet défavorable de réduire sensiblement la bande passante du tube amplificateur (définie généralement par rapport à une atténuation en puissance de -3db). En pratique, le produit gain de puissance x bande passante" est sensiblement constant pour un tube donné utilisé seul ou en un assemblage de plusieurs tubes montés en parallèle. Il a également été proposé de réaliser un amplificateur pour partie à constantes réparties en constituant une ligne de distribution dans laquelle les constantes localisées que représentent les tubes sont associées à des éléments inductifs complémentaires localisés pour créer une ligne de propagation en entrée (les capacités d'entrée associées à ces inductances réalisant ainsi un filtre passe-bas). D'une façon similaire, les capacités de sortie des tubes sont associées à des éléments inductifs localisés pour créer une ligne de propagation en sortie reliée à la charge utile de l'ensemble. Le brevet US - A - 3.808.546 décrit un agencement de ce type dans lequel un ensemble complet de plusieurs tubes est mis sous vide dans une enceinte commune.

Cette solution quoique représentant une amélioration a également ses limites dans le domaine de l'amplification HF à cause des valeurs élevées des capacités d'entrée et de sortie des tubes.

L'invention a notamment pour but de réaliser des dispositifs amplificateurs HF de puissance à large bande à performances améliorées.

A cet effet l'invention propose un dispositif de transmission de signaux à propagation d'ondes comportant outre des moyens de propagation d'ondes entre un point d'entrée E et un point de sortie S, des moyens actifs d'amplification des signaux en transit présentant deux moyens formant électrodes, une électrode émettrice de porteurs de charge éventuellement commandée d'une part et une électrode collectrice de porteurs de charge d'autre part, lesdits moyens formant électrodes étant intégrés auxdits moyens de propagation d'ondes et respectivement associés l'un au point d'entrée E des signaux, l'autre au point de sortie S des signaux, le dispositif étant caractérisé en ce que lesdits moyens de propagation d'ondes comportent deux structures de propagation d'ondes à constantes intégralement réparties couplées, l'une desdites structures intégrant lesdits moyens formant électrode émettrice (cathode) et des moyens formant grille de commande, sous la forme de plaques, grilles ou fils conducteurs linéaires et continus à l'intérieur de et dans toute la structure de propagation d'entrée, l'autre desdites structures intégrant lesdits moyens formant électrode collectrice (anode) et des moyens formant grille écran accélératrice et/ou grille-écran de découplage sortie/entrée, sous la forme de plaques, grilles ou fils conducteurs, linéaires et continus à l'intérieur de et dans toute la structure de propagation de sortie.

Ainsi donc, l'intégration sous la forme de composants linéaires et continus des moyens d'amplification aux moyens de propagation d'ondes permet de répartir les capacités d'entrée et de sortie le long des moyens de transmission de signaux à propagation d'ondes et d'atténuer leurs effets indésirables au niveau de la réduction de la bande passante, tout en profitant de l'accroissement de la puissance amplifiée résultant de l'augmentation des surfaces actives disponibles des électrodes pour les fonctions d'amplification ; ces surfaces dépendant directement des dimensions de ces mêmes moyens de propagation d'onde. Pour la suite de l'exposé, le dispositif selon l'invention sera également dénommé dispositif de propagation d'ondes, dispositif de propagation d'ondes à effet amplificateur ou simplement amplificateur.

Pour résumer, l'agencement linéaire et continu des composants de l'amplificateur HF (électrodes et grilles de commande et d'accélération) réalisé selon la présente invention permet d'accroître sensiblement la surface des électrodes par simple allongement des lignes de propagation constituant ces dernières (et d'obtenir une augmentation de la puissance de sortie) tout en limitant l'influence des capacités d'entrée et de sortie pour conserver une large bande passant à l'amplificateur. De même, la réduction des connexions électriques du circuit par rapport aux circuits connus entraîne une réduction des effets parasites des lignes d'interconnexion. Ainsi donc le dispositif selon l'invention présente une architecture simple et dépouillée basée sur deux lignes de propagation couplées sans éléments discrets, toute la structure du dispositif selon l'invention étant à constantes réparties.

Avantageusement dans le dispositif de propagation d'onde selon l'invention, l'électrode émettrice d'électrons ou cathode est commandée à partir du point d'entrée E des signaux et l'électrode collectrice d'électrons ou anode est associée au point de sortie S des signaux.

Il est à noter que le couplage ainsi réalisé des deux lignes de propagation d'ondes constituées d'une part par la cathode et sa grille de commande d'autre part par l'anode et sa grille d'accélération, permet d'obtenir en plus du phénomène d'amplification classique des signaux HF issus d'un générateur, la combinaison sur la charge utile des signaux de sortie HF ainsi amplifiés en phase. On obtient ainsi un accroissement sensible de la puissance de sortie, sans affecter la bande passante du dispositif.

Selon une première variante de réalisation de l'invention, les structures de propagation d'ondes sont du type coaxial et disposées soit selon un arrangement concentrique soit selon un arrangement juxtaposé. Dans la configuration juxtaposée un montage "push-pull" de deux sous-ensembles amplificateurs est également réalisé dans le cadre de la présente invention selon des caractéristiques techniques détaillées dans la description ci-après.

Selon une seconde variante de réalisation de l'invention, les structures de propagation d'ondes sont du type à plaques linéaires parallèles ou bandes (bi-plaque ou tri-plaque) lesdites structures étant empilées face contre face de façon à disposer en position externe les deux plaques intégrant les électrodes. Dans cette configuration à plaques linéaire parallèles ("strip-line) le montage "push-pull" de deux sous-ensembles amplificateurs est également réalisé.

L'invention est mise en oeuvre dans des dispositifs de transmission de signaux à propagation d'ondes à effet amplificateur selon une technologie du type à enceinte sous vide ou selon une technologie type "état-solide".

L'invention concerne également des applications des dispositifs de transmission de signaux à propagation d'ondes à effet amplificateur, notamment à l'amplifications H.F. couvrant des bandes passantes atteignant plusieurs gigahertz, à la génération d'impulsions électromagnétiques puissantes de longue durée et à front de montée trè raide et à la simulation de la foudre ou d'ondes analogues.

Selon encore une autre variante de réalisation de l'invention, les deux structures à propagation d'ondes à constantes intégralement réparties du dispositif de transmission de signaux comportent deux lignes unitaires couplées se présentant sous la forme d'un arrangement parallèle ou coaxial de plaques, grilles ou fils conducteurs chaque ligne constituant une des dites électrodes, l'une ligne émissive, respectivement cathode et grille de commande, et l'autre ligne collectrice, respectivement anode, et grille accélératrice et/ou de découplage, les dites lignes émissive et collectrice du flux de porteurs de charge (électrons) se présentant spécifiquement sous une forme linéaire et continue pour constituer des lignes de propagation à constantes intégralement réparties couplées entre elles de façon interactive.

Avantageusement la ligne d'entrée émissive forme la cathode et la grille de contrôle à partir du point d'entrée E des signaux, et la ligne de sortie collectrice forme l'anode associée au point de sortie S des signaux et les grilles accélératrices et de découplage.

D'autres avantages et caractéristiques de la présente invention apparaîtront à la lecture de la description qui va suivre dans laquelle sont présentés, sans caractère limitatif, plusieurs modes de réalisation de l'invention en référence aux dessins ci-annexés dans lesquels :
- la figure 1 représente un vue schématique partielle en perspective d'un premier mode de réalisation d'un dispositif de propagation d'ondes selon l'invention détaillant les structures de propagation d'ondes de type coaxial disposées selon un arrangement juxtaposé,
- la figure 2 représente une vue schématique partielle en perspective d'un second mode de réalisation d'un dispositif de propagation d'ondes selon l'invention détaillant les structures de propagation d'ondes de type coaxial disposées selon un arrangement concentrique,
- la figure 3 représente le schéma de principe du circuit d'un amplificateur de puissance HF selon l'invention du type à enceinte à vide utilisant les structures de propagation d'ondes illustrées à la figure 1 (ici représentées en sections axiale et diamétrale),
- la figure 4 représente le schéma de principe du circuit d'un amplificateur de puissance HF selon l'invention du type à enceinte à vide utilisant les structures de propagation d'ondes illustrées la figure 2 (ici représentées en sections axiale et diamétrale),
- la figure 5 représente le schéma de principe d'un circuit d'un amplificateur de puissance HF selon l'invention du type à enceinte à vide réalisé par montage "push-pull" de deux dispositifs de propagation d'ondes selon l'invention à structures de propagation de type coaxial juxtaposées (ici représentées en sections axiale et diamétrale),
- la figure 6 représente le schéma de principe d'un circuit d'un amplificateur de puissance HF du type à enceinte à vide constitué par un dispositif de propagation d'ondes selon l'invention à structures de propagation de type à bande ("strip-line"),
- la figure 7 représente une vue éclatée d'un mode de réalisation des structures à propagation d'ondes incorporées dans le dispositif selon l'invention représenté à la figure 6,
- la figure 8 représente une vue en perspective d'un empilement de structures de propagation de type à plaques linéaires parallèles susceptible d'être incoporé dans un tube amplificateur de puissance HF de type "push-pull" selon l'invention,
- et la figure 9 représente une vue en perspective d'un empilement de structures de propagation d'ondes réalisé en technologie "état-solide" et susceptible d'être utilisé dans un dispositif de propagation d'ondes à l'effet amplificateur selon l'invention.

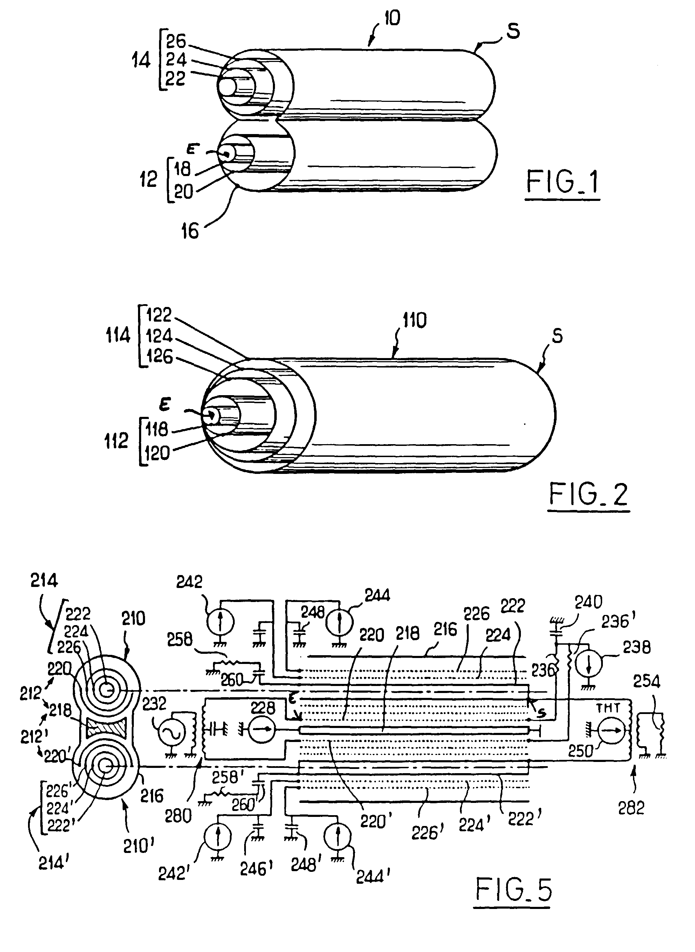

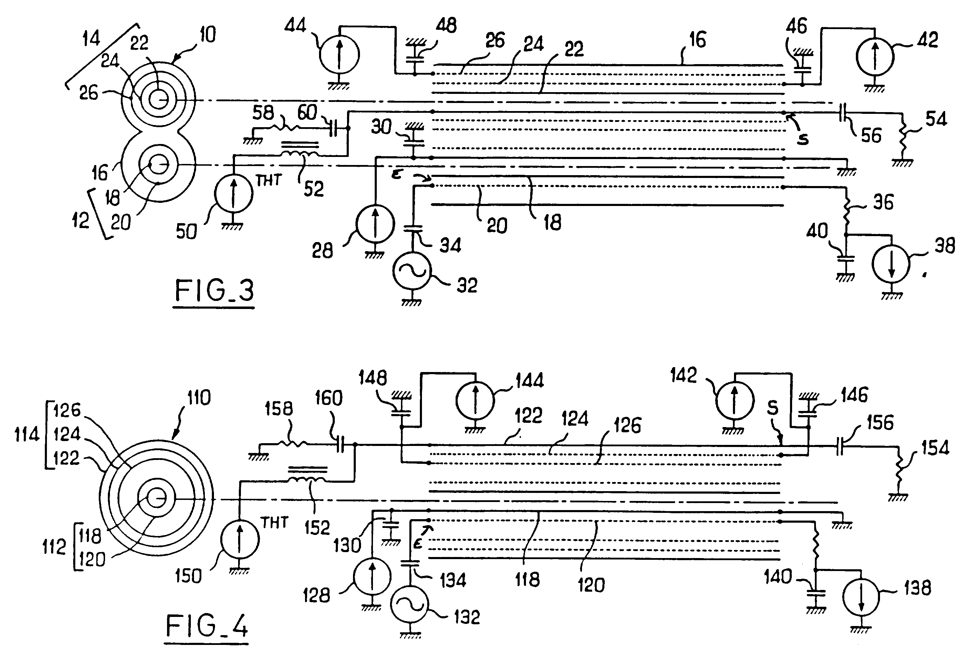

Le dispositif de propagation d'ondes à effet amplificateur illustré à la figure 3 est obtenu à partir de moyens de propagation d'ondes représentés à la figure 1 constitué par un assemblage 10 de deux structures 12 et 14 de propagation d'ondes à constante réparties de type coaxial juxtaposées et insérées dans une enveloppe de protection 16. Pour la suite de l'exposé on considérera que l'onde ou les signaux HF en transit le long de ces structures de propagation se propagent d'un point d'entrée (ou extrémité) E vers un point de sortie (ou extrémité) S.

Le dispositif de propagation d'ondes selon l'invention qui constitue de façon générale un amplificateur de puissance HF est réalisé à partir du montage dans une enceinte à vide de l'assemblage 10 selon le schéma du principe illustré à la figure 3 pour obtenir la variante "tube amplificateur à vide" de l'invention, plus exactement un tube amplificateur à propagation d'ondes sous vide de type distribué.

La première structure de propagation d'ondes ou ligne coaxiale 12 se présentant sous la forme de composants linéaires et continus sert de source distribuée émissive de porteurs de charge électrique (dans le cas présent des électrons) à partir de l'âme 18 de la ligne 12 tandis que le corps 20 fait fonction de grille de commande destinée à contrôler à partir de signaux HF le flux d'électrons émis vers la seconde structure ou ligne coaxiale 14. La ligne coaxiale 14 se présentant egalement sous la forme de composants linéaires et continus fait fonction de récepteur des électrons émis. A cet effet, l'âme 22 sert de collecteur d'électrons et représente l'anode, tandis que le corps, constitué à titre d'exemple non limitatif de deux couches ou grilles écrans 24 et 26, est utilisé comme électrode d'accélération et de découplage pour empêcher la propagation inverse des signaux de sortie vers l'entrée ( les signaux amplifiés en sortie ne devant pas perturber les signaux à amplifier à l'entrée).

Les diverses électrodes et grilles présentées ci-dessus sont intégrées dans le circuit d'amplification illustré à la figure 3 de la façon suivante :
- la cathode 18 est alimentée par un circuit de chauffage comportant un générateur de tension 28 et une capacité de découplage 30.
- la grille de commande 20 reçoit au point d'entrée E du dispositif de propagation d'ondes 10 un signal HF à amplifier d'un générateur HF 32 au travers d'une capacité d'entrée 34. Le point de sortie S de la grille 20 est relié par une impédance de charge 36 à un générateur 38 de tension de polarisation de la grille 20 et à une capacité de découplage 40.
- les deux grilles écrans 24 et 26 sont convenablement polarisées de façon indépendante par des générateurs de tension 42 et 44 associés à deux capacités de découplage 46 et 48.
- l'anode 22 est reliée à un générateur de très haute tension THT 50 (par exemple entre 400 et 500 volts) par l'intermédiaire d'une inductance 52. Cette anode est convenablement chargée au point de sortie S par une impédance d'utilisation (charge utile) 54 au travers d'une capacité de sortie 56. La ligne de propagation constituée par l'anode 22 est adaptée au point d'entrée E à l'aide d'une impédance de charge "inverse" 58 au travers d'une capacité d'entrée 60.

Ainsi donc, les électrodes et les grilles de commande et d'écran qui constituent des moyens d'amplification actifs des signaux HT sont intégrées sous forme de composants linéaires et continus aux structures de propagation de ces mêmes signaux, la propagation étant réalisée en mode distribué.

Le fonctionnement de l'amplificateur illustré à la figure 3 découle de celui d'un tube à vide classique du type cathode/grille de commande/anode. Toutefois, le couplage ainsi réalisé des deux lignes de propagation d'ondes constituées, d'une part par la cathode 18 et sa grille de commande 20, d'autre part par l'anode 22, permet d'obtenir en plus du phénomène d'amplification classique des signaux HF issus du générateur 32, la combinaison sur la charge utile 54 des signaux de sortie HF ainsi amplifiés en phase. On obtient ainsi un accroissement sensible de la puissance de sortie, sans affecter la bande passante du dispositif. Il est intéressant de remarquer que l'agencement linéaire et continu des composants de l'amplificateur HF (électrodes et grilles de commande et d'accelération) réalisé selon la présente invention permet d'accroître sensiblement la surface des électrodes par simple allongement des lignes de propagation constituant ces dernières (et d'obtenir une augmentation de la puissance de sortie) tout en limitant l'influence des capacités d'entrée et de sortie pour conserver une large bande passante à l'amplificateur. De même, la réduction des connexions électriques du circuit par rapport aux circuits connus entraîne une réduction des effets parasites des lignes d'interconnexion.

A titre d'exemple non limitatif, l'invention est utilisable en mode continu (CW) comme amplificateur HF avec des puissances de sortie supérieures à 1000 watts et une bande passante pouvant atteindre plusieurs gigahertz. En mode impulsionnel l'invention est utilisée pour obtenir des puissances de sortie de l'ordre de la centaine de kilowatts (avec une surface de cathode d'environ 1000 cm2 pour une longueur d'électrode voisine d'un mètre). Dans ce mode impulsionnel, les tubes amplificateurs selon l'invention sont utilisés pour générer des impulsions électroniques puissantes de longue durée et à front de montée très raide, ou comme éclateurs et/ou comme simulateurs de foudre ou d'ondes analogues et/ou dans la commutation rapide avec effet d'amplification.

L'invention présente également d'autres avantages, notamment par rapport aux tubes à ondes progressives (T.O.P.), plus fragiles et plus coûteux, en particulier celui d'avoir une plus faible teneur en harmoniques en sortie d'amplification du fait de l'amélioration de la linéarité entre les signaux entrée et sortie.

Le dispositif de propagation d'ondes à effet amplificateur illustré sur les figures 2 (en partie) et 4 est similaire à celui illustré sur les figures 1 et 3 décrit précédemment. La description de ce second dispositif selon l'invention ne sera pas reprise en détails ci-après, toutefois, les composants identiques ou analogues à ceux du premier dispositif selon l'invention déjà décrit en référence aux figures 1 et 3 sont repérés sur les figures 2 et 4 avec les mêmes références numériques (augmentées de 100) que celles utilisées pour la description des composants correspondants du premier dispositif selon l'invention.

Dans ce second dispositif de propagation d'ondes à effet amplificateur qui se présente également sous la forme d'un tube à vide, les deux structures de propagation d'ondes couplées 112 et 114 sont disposées selon un agencement coaxial dans une enceinte à vide. Dans ce cas, la structure constituant l'électrode émissive d'électrons commandée (cathode 118 et grille de commande 120) est disposée au centre de l'agencement tandis que l'anode collectrice d'électrons 122 est placée en position périphérique comme illustré sur les figures 2 et 4.

Le fonctionnement de l'amplificateur de puissance HF de la figure 4 est identique dans son principe à celui de l'amplificateur de la figure 3.

Le choix de l'un ou l'autre type d'amplificateur selon l'invention dépendra en fait de l'utilisation recherchée et des deux conditions d'utilisation. En effet, l'amplificateur de la figure 3 à agencement juxtaposé apparaît mieux adapté aux gains en puissance élevés pour des fréquences élevées. L'amplificateur de la figure 4 est moins encombrant, plus cohérent et offre une plus grande régularité du cheminement cathode/anode. Il est toutefois plus sensible à la technologie utilisée des connexions entrée/sortie. Des couplages intempestifs peuvent apparaître entraînant des sur-oscillations (accrochages ou auto-oscillations) ou des atténuations indésirables dans la bande de fréquence amplifiée.

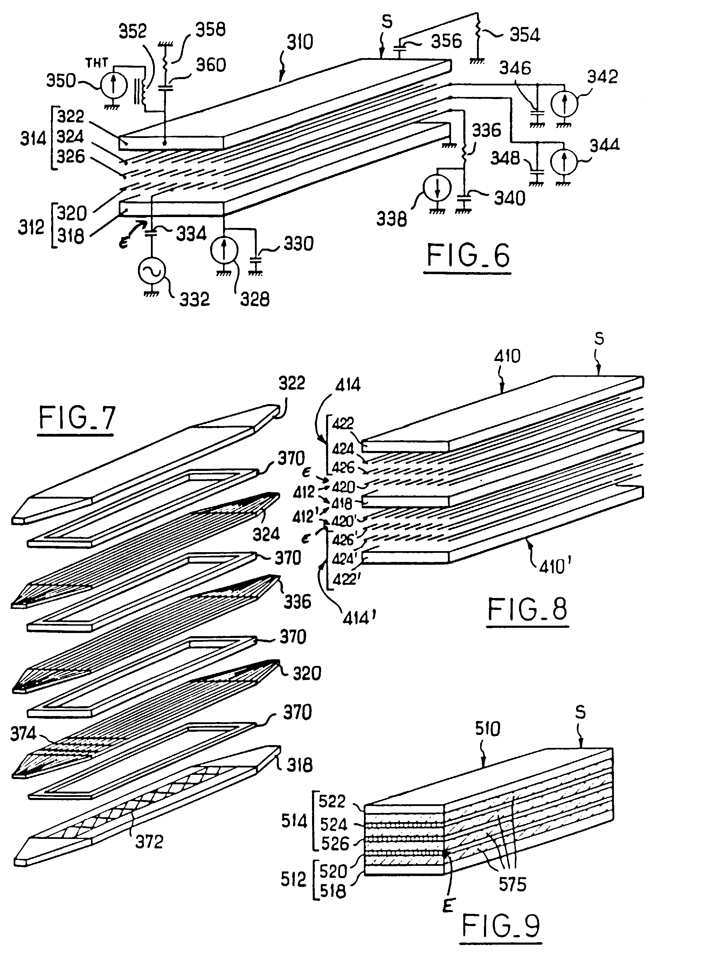

La figure 5 montre un autre amplificateur HF de puissance selon l'invention également sous la forme d'un tube à vide et incorporant un montage dit "push-pull" parallèle à transformateurs d'entrée et de sortie. Une fois encore la description de cet amplificateur qui comporte de nombreux composants identiques ou analogues à ceux décrits en référence à l'amplificateur illustré à la figure 3 ne sera pas reprise en détail (on utilisera les mêmes références numériques augmentées de 200 pour les composants correspondants).

L'amplificateur HF de la figure 5 est agencé autour d'une paire de deux ensembles 210 et 210' de propagation d'ondes disposés dans une enceinte à vide et comportant chacune deux structures de propagation d'ondes de type coaxial couplées selon une disposition concentrique (212-214, 212'-214').

Toutefois, dans l'agencement présent, la cathode 218, placée en position intermédiaire tangentielle pour chaque ensemble 210 et 210' est commune et disposée à ni-distance entre les anodes 222 et 222' selon le montage symétrique illustré à la figure 5.

Le transformateur d'entrée 280 à point milieu au secondaire commande à partir du point d'entrée E les tensions des grilles de commande 220 et 220' à partir du primaire monté en sortie du générateur HF 232. Le transformateur 280 permet de faire émettre alternativement la cathode 218 vers les anodes 222 et 222'.

Le transformateur de sortie 282 est à point milieu au primaire. Chaque demi-primaire est relié au point de sortie S de l'anode 222 et 222' correspondante qui travaillent alternativement l'une après l'autre. La charge utile 254 est placée sur le secondaire.

Le fonctionnement HF en mode "push-pull" de l'amplificateur illustré à la figure 5 est classique en ce qui concerne ce type de montage de sous-ensembles amplificateurs. D'une façon globale, les montages "push-pull" permettent une augmentation de la puissance de sortie et une amélioration des rendements.

La figure 6 montre le schéma de principe d'un amplificateur de puissance HF selon l'invention également sous la forme d'un tube à vide. Une fois encore la description de cet amplificateur qui comporte de nombreux composants identiques ou analogues à ceux décrits en référence avec l'amplificateur de la figure 3 ne sera pas reprise en détail (on utilisera les mêmes références numériques augmentées de 300 pour les composants correspondants).

Par rapport aux amplificateurs précédemment décrits dont les structures de propagation d'ondes couplées étaient du type coaxial, l'amplificateur de la figure 6 incorpore dans une enceinte à vide deux structures de propagation d'ondes couplées du type à plaques parallèles linéaires ou bandes, l'une bi-plaque référencée 312, l'autre tri-plaque référencée 314. Les structures à plaques parallèles linéaires et continues ("strip-lines") 312 et 314 sont empilées face contre face de façon à disposer en position externe les deux plaques constituant les électrodes (la cathode 318 et l'anode 322). La structure 312 comporte également la grille de commande 320 dont le point d'entrée E est connecté par la capacité 334 au générateur de tension HF 332. Les signaux HF amplifiés sont receuillis en phase à la sortie S de la structure de propagation 314 sur la charge utile 354 convenablement associée à l'anode 322.

La figure 7 montre une vue éclatée de l'empilement des structures de propagation d'ondes couplées de l'amplificateur illustré à la figure 6. Les espacements entre les électrodes 318, 322 et/ou les grilles 320, 326, 324 sont prédéterminés par l'insertion de cadres en céramique 370 faisant office d'entretoise (éventuellement d'épaisseurs différentes).

Dans une variante (non représentée) de l'invention, les entretoises font partie intégrante de cloisons céramiques pourvues de gorges dans lesquelles sont insérées les grilles ; ce montage évite les fuites possibles au niveau soudures céramique/métal en diminuant le nombre de ces dernières.

A titre d'exemple non limitatif dans le mode de réalisation ici décrit, la cathode est du type à chauffage indirect (650 °C) réalisée à partir de dépôt d'oxyde de baryum et de strontium.

L'émissivité obtenue est comprise entre 0,2 et 0,3 Ampères par cm2 de surface de cathode, ce qui en mode pulsé permet d'obtenir un courant émis de 200 à 300 mA/cm2 par watt de chauffage ou en mode continu (CW) un courant émis de 20 à 30 mA/cm2 par watt de chauffage.

Toujours à titre d'exemple non limitatif, une surface de cathode de 50cm2 (25cm de longueur active X 2 cm de largeur active), permet d'obtenir un courant de plaque Ip moyen de 10 Ampères. Les impédances de la ligne d'entrée et de la ligne de sortie de l'amplificateur sont choisies de façon classique à 50 Ohms. L'adaptation des deux lignes notamment au niveau des capacités entraîne des dimensions prédéterminées des distances cathode-grille de commande et anode-grille de commande (cette dernière étant fixée environ au double de la première). Il en résulte une largeur active d'anode du double de celle de la cathode, soit dans l'exemple présenté une largeur d'anode de l'ordre de 4cm. D'une façon pratique la cathode présente une zone centrale active 372 telle que représentée schématiquement sur la figure 7. Les grilles sont réalisées selon un maillage carré (représenté partiellement en 374) de fil conducteur fin avec un espacement égal à quatre fois le diamètre du fil.

En ce qui concerne les tensions de polarisation on a choisi la tension d'anode Vp entre 400 et 500 Volts, la tension de grille de commande 320 Vg1 à -25 Volts et la tension de la grille écran accélératrice Vg2 à 150 V. Ainsi donc pour un signal d'entrée sur la grille de commande de + 25 Volts (sur 50 Ohms), on obtient un signal de sortie VS de + 250 Volts (sur 50 Ohms), le courant plaque délivré Ip étant de 10 Ampères en crête.

La figure 8 montre une vue schématique d'un empilement de deux ensembles de propagation d'ondes 410 et 410' comportant chacun deux structures de propagation à bande couplées 412-414 et 412'-414'. Dans ce montage en "sandwich" particulier, les ensembles de propagation d'ondes 410 et 410' sont juxtaposés avec la cathode 418 commune en position médiane. Un tel agencement est utilisé pour la réalisation d'un amplificateur HF selon l'invention de type "push-pull" selon un circuit électrique analogue à celui décrit en référence à la figure 5.

La figure 9 montre une vue schématique d'un empilement 510 de structures de propagation de type à plaques linéaires parallèles réalisé en technologie "état-solide" utilisable dans un dispositif de propagation d'ondes à effet amplificateur selon l'invention. A titre d'exemple non limitatif, la cathode 518 et l'anode 522 sont réalisées en tungstène ou en nickel (éventuellement doré) les grilles de commande 520 et les grilles écrans 524 et 526 en maillage de fil fin, les électrodes et/ou les grilles étant séparées par des couches 575 de matériau semi-conducteur de préférence à base de silicium. Il est à noter pour terminer que la technologie "état-solide" est également applicable aux structures de propagation d'ondes de type coaxial. L'invention n'est pas limitée aux modes de réalisation décrits ci-avant. En particulier, l'invention concerne également tout dispositif constitué de deux lignes de propagation couplées placées dans une enceinte sous vide (les lignes étant de type coaxial ou du type "strip-lines" et dans lequel la fonction d'amplification est réalisée de la façon suivante:
- Le conducteur n°1 d'une des lignes, la ligne A par exemple, est rendu actif pour remplir la fonction de cathode et de source d'électrons obtenus par échauffement de ce conducteur, le conducteur n°2 de cette même ligne A servant à contrôler, à partir de signaux HF injectés en entrée de la ligne, le flux d'électrons émis par la cathode ;
- Le conducteur n°1 de l'autre ligne, ligne B par exemple, placée adjacente à la première (ligne A) sert au découplage sortie vers entrée entre les lignes et à accélerer le flux d'électrons pour l'acheminer vers le conducteur n°2 de cette autre ligne B qui remplit la fonction d'anode collectrice des électrons, ce conducteur n°2 étant associé en sortie de la ligne B à une charge d'utilisation pour les signaux HF amplifiés ;
- le tout constituant un amplicateur en lignes à constantes réparties placées dans une enveloppe unique sous vide.

## Revendications

1. Dispositif de transmission de signaux à propagation d'ondes comportant, outre des moyens de propagation d'ondes (10) entre un point d'entrée E et un point de sortie S, des moyens actifs d'amplification des signaux en transit (18, 20, 22) présentant deux moyens formant électrodes, une électrode (18, 20) émettrice de porteurs de charge commandée d'une part et une électrode (22) collectrice de porteurs de charge d'autre part, lesdits moyens formant électrodes (18, 20, 22) étant intégrés auxdits moyens de propagation d'ondes (10) et respectivement associés l'un au point d'entrée E des signaux, l'autre au point de sortie S des signaux, le dispositif étant caractérisé en ce que lesdits moyens de propagation d'ondes (10) comportent deux structures de propagation d'ondes à constantes intégralement réparties (12, 14) couplées, l'une (12) desdites structures intégrant lesdits moyens formant électrode émettrice (cathode) (18) et des moyens formant grille de commande (20), sous la forme de plaques, grilles ou fils conducteurs linéaires et continus à l'intérieur de et dans toute la structure de propagation d'entrée, l'autre (14) desdites structures intégrant lesdits moyens formant électrode collectrice (anode) (22) et des moyens formant grille-écran accélératrice, et/ou grille-écran de découplage sortie/entrée (24,26), sous la forme de plaques, grilles ou fils conducteurs liniéaires et continus à l'intérieur de et dans toute la structure de propagation de sortie.

2. Dispositif selon la revendication 1, caractérisé en ce que les deux structures de propagation (12-14, 112-114, 212-214) sont du type coaxial et disposées soit selon un arrangement concentrique (112-114), soit selon un arrangement juxtaposé (12-14, 212-214).

3. Dispositif selon la revendication 2, caractérisé en ce qu'il est constitué par une paire de sous-ensembles amplificateurs comportant chacun des moyens de propagation d'ondes (210, 210') à structures de propagation de type coaxial, les électrodes (218, 220-220', 222-222') étant intégrées auxdites structures selon une disposition dans laquelle la cathode (218) est en position intermédiaire entre deux structures coaxiales, lesdits sous-ensembles amplificateurs étant agencés de façon juxtaposée à cathode (218) commune et associés selon un montage de type "push-pull".

4. Dispositif selon la revendication 1, caractérisé en ce que les deux structures de propagation d'ondes (312, 314) sont du type à plaques linéaires parallèles ou bandes (bi-plaques) (312) ou tri-plaques (314)) lesdites structures étant empilées face contre face de façon à disposer en position externe les deux plaques (318, 322) intégrant les électrodes.

5. Dispositif selon la revendication 4, caractérisé en ce qu'il est constitué par une paire de sous-ensembles amplificateurs comportant chacune des moyens de propagation d'ondes (410, 410') à structures de propagation de type à plaques parallèles, lesdits sous-ensembles amplificateurs étant disposés de façon juxtaposée à cathode commune (418) en position médiane et associés selon un montage du type "push-pull".

6. Dispositif selon l'une des revendications précédentes caractérisé en ce que l'électrode (18,20) émettrice d'électrons ou cathodes est commandée à partir du point d'entrée E des signaux à amplifier et en ce que l'électrode (22) collectrice d'électrons ou anode est associée au point de sortie S desdits signaux.

7. Dispositif selon l'une des revendications précédentes caractérisé en ce que le fonctionnement actif des deux structures de propagation d'ondes s'effectue dans une enceinte sous vide.

8. Dispositif selon l'une des revendications 1 à 6, caractérisé en ce qu'il est réalisé en technologie "état-solide".

9. Application des dispositifs de transmission de signaux à propagation d'ondes selon l'une des revendications 1 à 7 à la génération d'impulsions électromagnétiques puissantes de longue durée et à front de montée très raide.

10. Application des dispositifs de transmission de signaux à propagation d'ondes selon l'une des revendications 1 à 7 la simulation de la foudre ou d'ondes analogues.

11. Application des dispositifs de transmission de signaux à propagation d'ondes selon l'une des revendications 1 à 8 à la commutation rapide avec effet d'amplification.

12. Application des dispositifs de transmission de signaux à propagation d'ondes selon l'une des revendications 1 à 8 à l'amplification des signaux HF à très large bande passante atteignant plusieurs gigahertz.

13. Dispositif selon la revendication 1, caractérisé en ce que les deux structures à propagation d'ondes (12, 14) à constantes intégralement réparties comportent deux lignes unitaires couplées se présentant sous la forme d'un arrangement parallèle ou coaxial de plaques, grilles ou fils conducteurs, chaque ligne constituant une desdites électrodes, l'une ligne émissive, respectivement cathode (18) et grille de commande (20), et l'autre ligne collectrice, respectivement anode (22), et grille accélératrice (24) et/ou de découplage (26), lesdites lignes émissive et collectrice du flux de porteurs de charge (électrons) se présentant spécifiquement sous une forme linéaire et continue pour constituer des lignes de propagation à constantes intégralement réparties couplées entre elles de façon interactive.

14. Dispositif selon la revendication 13, caractérisé en ce que la ligne d'entrée émissive forme la cathode emissive (18) et la grille de contrôle (20) commandée à partir du point d'entrée E des signaux, et en ce que la ligne de sortie collectrice forme l'anode (22) associée au point de sortie S des signaux et les grilles accélératrice (24) et de découplage (26).

## Patentansprüche

1. Vorrichtung zur Signalübertragung mit Wellenausbreitung umfassend, außer Mitteln (10) zur Wellenausbreitung zwischen einem Eingangspunkt E und einem Ausgangspunkt S, aktive Mittel zur Verstärkung der sogenannten Transitsignale (18, 20, 22), welche zwei Elektroden bildende Mittel, eine Sendeelektrode (18, 20) für Träger gesteuerter Ladung einerseits und eine Sammelelektrode (22) für Ladungsträger andererseits, aufweisen, wobei diese Mittel Elektroden (18, 20, 22) bilden, die in diese Wellenausbreitungsmittel (10) integriert und jeweils das eine dem Eingangspunkt E der Signale, das andere dem Ausgangspunkt S der Signale zugeordnet sind, wobei die Vorrichtung sich dadurch auszeichnet, daß dieses Signalausbreitungsmittel (10) Wellenausbreitungsstrukturen mit integral verteilten gekoppelten Konstanten (12, 14) umfassen, und eine (12) dieser Strukturen diese die Sendeelektrode (Kathode) (18) bildenden Mittel und Steuergitter bildende Mittel (20) in Form von Platten, Gittern oder leitenden linearen und kontinuierlichen Drähten im Inneren von und in der gesamten Eingangsfortpflanzungsstruktur integriert, und die andere (14) dieser Strukturen diese die Sammelelektrode (Anode) (22) bildenden Mittel und Gitter-Beschleunigungsschirm und/oder Gitter-Ausgangs/Eingangsentkopplungsschirm (24) bildende Mittel, in Form von Platten, Gittern oder linearen und kontinuierlichen Drähten im Inneren von und in der gesamten Ausgangsausbreitungsstruktur integriert.

2. Vorrichtung nach Anspruch 1, dadurch gekennzeichnet, daß die beiden Wellenausbreitungsstrukturen (12-14, 112-114, 212-214) vom Koaxialtyp sind und entweder gemäß einer konzentrischen Anordnung (112-114) oder gemäß einer nebeneinander befindlichen Anordnung (12-14, 212-214) angeordnet sind.

3. Vorrichtung nach Anspruch 2, dadurch gekennzeichnet, daß sie gebildet ist durch ein Paar von Verstärkerunteranordnungen, die je Wellenausbreitungsmittel (210, 210') mit Ausbreitungsstrukturen vom Koaxialtyp umfassen, wobei die Elektroden (218, 220-220', 222-222') in diese Strukturen gemäß einer Anordnung integriert sind, in welcher die Kathode (218) in Zwischenposition zwischen zwei koaxialen Strukturen sich befindet, und die Verstärkerunteranordnungen in Nebeneinanderanordnung zur gemeinsamen Kathode (218) ausgebildet und gemäß einer "Push-Pull"-Montage zugeordnet sind.

4. Vorrichtung nach Anspruch 1, dadurch gekennzeichnet, daß die beiden Wellenausbreitungsstrukturen (312, 314) vom Typ mit linearen parallelen Platten oder Banden (Zweifachplatten (312) oder Dreifachplatten (314)) sind, wobei die Strukturen stirnseitig gegeneinander derart gestapelt sind, daß sie in Außenstellung die beiden Platten (318, 322) die Elektroden integrierend anordnen.

5. Vorrichtung nach Anspruch 4, dadurch gekennzeichnet, daß sie gebildet ist durch ein Paar von Verstärkerunteranordnungen, die je Wellenausbreitungsmittel (410, 410') mit Wellenausbreitungsstrukturen vom Typ mit parallelen Platten umfassen, wobei diese Verstärkerunteranordnungen nebeneinander angeordnet zu einer gemeinsamen Kathode (418) in Mittelstellung vorgesehen und gemäß einer Montage vom "Push-Pull"-Typ einander zugeordnet sind.

6. Vorrichtung nach einem der vorhergehenden Ansprüche, dadurch gekennzeichnet, daß die Elektronen aussendende Elektrode (18, 20) oder Kathoden gesteuert wird ausgehend von dem Eingangspunkt E der zu verstärkenden Signale und daß die Sammlerelektrode (22) für Elektronen oder Anode dem Ausgangspunkt S dieser Signale zugeordnet ist.

7. Vorrichtung nach einem der vorhergehenden Ansprüche, dadurch gekennzeichnet, daß die aktive Arbeitsweise der beiden Wellenausbreitungsstrukturen in einer Kammer unter Vakuum stattfindet.

8. Vorrichtung nach einem der Ansprüche 1 bis 6, dadurch gekennzeichnet, daß sie in der "Fester-Zustand"-Technologie realisiert ist.

9. Anwendung der Signalübertragungsvorrichtungen auf die Wellenausbreitung nach einem der Ansprüche 1 bis 7 auf die Erzeugung leistungsstarken elektromagnetischer Impulse langer Dauer und sehr steiler Anstiegsflanke.

10. Anwendung der Signalübertragungsvorrichtungen mit Wellenausbreitung nach einem der Ansprüche 1 bis 7 auf die Simulation des Blitzes oder analoger Wellen.

11. Anwendung der Signalübertragungsvorrichtungen mit Wellenausbreitung nach einem der Ansprüche 1 bis 8 auf die schnelle Umschaltung mit Verstärkereffekt.

12. Anwendung der Signalübertragungsvorrichtungen mit Wellenausbreitung nach einem der Ansprüche 1 bis 8 auf die Verstärkung von HF Signalen mit sehr breitem Bandpaß, Signalen, die mehrere Gigahertz erreichen.

13. Vorrichtung nach Anspruch 1, dadurch gekennzeichnet, daß die beiden Strukturen mit Wellenausbreitung (12, 14) mit integral verteilten Konstanten zwei gekoppelte Einheitsleitungen umfassen, die in Form einer Parallel- oder Koaxialanordnung von Platten, Gittern oder leitenden Drähten vorliegen, wobei jede Leitung eine dieser Elektroden bildet, die eine, sendende Leitung, bzw. Kathode (18) und Steuergitter (20), und die andere Sammelleitung bzw. Anode (22) und Beschleunigungsgitter (24) und/oder Entkopplungsgitter (26), wobei diese Sende- und Sammelleitung des Flusses von Ladungsträgern (Elektronen), spezifisch in einer linearen und kontinuierlichen Form vorliegen, um Leitungen mit Wellenausbreitung mit integral verteilten Konstanten, die interaktiv miteinander gekoppelt sind, zu bilden.

14. Vorrichtung nach Anspruch 13, dadurch gekennzeichnet, daß die Eingangssendeleitung die sendende Kathode (18) und das Regelgitter gesteuert ausgehend vom Eingangspunkt E der Signale bildet und daß die Sammelausgangsleitung die Anode (22), zugeordnet zum Ausgangspunkt S der Signale sowie die Beschleunigungs- (24) und Entkopplungsgitter (26) bildet.

## Claims

1. Wave propagating signal transmitting device comprising, in addition to means for the propagation of waves (10) between an input point E and an output point S, active means for the amplification of the signals in transit (18, 20, 22) having two means forming electrodes, a controlled charge carrier emitting electrode (18, 20) on the one hand and a charge carrier collecting electrode (22) on the other hand, said means forming electrodes (18, 20, 22) being incorporated in said wave propagating means (10) and one being associated with the signal input point E and the other with the signal output point S respectively, the device being characterised in that said wave propagating means (10) comprise two coupled wave propagating structures having integrally distributed constants (12, 14), one (12) of said structures incorporating said means forming the emitting electrode (cathode) (10) and means forming a control grid (20) in the form of plates, grids or linear and continuous conducting wires in the interior of and in the entire input propagating structure, the other (14) of said structures incorporating said means forming a collecting electrode (anode) (22) and means forming an accelerating grid-screen and/or output/input decoupling grid-screen (24, 26) in the form of plates, grids or linear and continuous conducting wires in the interior of and in the entire output propagating structure.

2. Device according to claim 1, characterised in that the two propagating structures (12-14, 112-114, 212-214) are of the coaxial type and are arranged either in a concentric arrangement (112-114) or in a juxtaposed arrangement (12-14, 212-214).

3. Device according to claim 2, characterised in that it consists of a pair of amplifying subassemblies each comprising wave propagating means (210, 210') having coaxial type propagating structures, the electrodes (218, 220-220', 222-222') being integrated in said structures in an arrangement in which the cathode (218) is in an intermediate position between two coaxial structures, said amplifying subassemblies being arranged in a juxtaposed manner with a common cathode (218) and being connected in a push-pull type assembly.

4. Device according to claim 1, characterised in that the two wave propagating structures (312, 314) are of the type with parallel linear plates or strips (bi-plates (312) or tri-plates (314)), said structures being stacked face to face so as to arrange the two plates (318, 322) incorporating the electrodes in an external, position.

5. Device according to claim 4, characterised in that it consists of a pair of amplifying subassemblies each comprising wave propagating means (410, 410') having propagating structures of the type with parallel plates, said amplifying subassemblies being arranged in a juxtaposed manner with a common cathode (418) in a median position and being connected in a push-pull type assembly.

6. Device according to one of the preceding claims, characterised in that the electron emitting electrode (18, 20) or cathode is controlled from the input point E of the signals to be amplified and in that the electron collecting electrode (22) or anode is connected to the output point S of said signals.

7. Device according to one of the preceding claims, characterised in that the active operation of the two wave-propagating structures takes place in a vacuum chamber.

8. Device according to one of claims 1 to 6, characterised in that it is produced by solid state technology.

9. Application of the wave propagating signal transmitting devices according to one of claims 1 to 7 to the generation of powerful electromagnetic pulses of long duration with a very steep rising edge.

10. Application of the wave propagating signal transmitting devices according to one of claims 1 to 7 to the simulation of lightning or similar waves.

11. Application of the wave propagating signal transmitting devices according to one of claims 1 to 8 to rapid switching with an amplifying effect.

12. Application of the wave propagating signal transmitting devices according to one of claims 1 to 8 to the amplification of HF signals with a very wide bandwidth attaining several gigahertz.

13. Device according to claim 1, characterised in that the two wave propagating structures (12, 14) having integrally distributed constants comprise two coupled unit lines having the form of a parallel or coaxial arrangement of plates, grids or conducting wires, each line constituting one of said electrodes, one being an emitting line or cathode (18) and control grid (20) and the other a collecting line or anode (22) and accelerating grid (24) and/or decoupling grid (26), said charge carrier (electron) flux emitting and collecting lines specifically having a linear and continuous shape to constitute propagation lines having integrally distributed constants coupled to one another in an interactive manner.

14. Device according to claim 13, characterised in that the emitting input line forms the emitting cathode (18) and the control grid (20) controlled from the signal input point E and in that the collecting output line forms the anode (22) connected to the signal output point S and the accelerating grids (24) and decoupling grids (26).
